# EUROPEAN PATENT APPLICATION

(11) **EP 4 668 561 A1**
(43) Date of publication of application: **24.12.2025**
(21) Application number: 25183382.8
(22) Date of filing: 17.06.2025
(51) Int. Cl.: H02M 1/12, G01R 31/327, H02M 1/32, H02M 7/48, H02M 7/5387

(54) **PHOTOVOLTAIC INVERTER SYSTEM, GRID-CONNECTED INVERTER AND RELAY FAILURE DETECTION METHOD THEREOF**

(30) Priority: 19.06.2024 CN 202410796069; 19.06.2024 CN 202421414325 U
(71) Applicant: Solax Power Network Technology (Zhejiang) Co., Ltd., Zhejiang 311599 (CN)
(72) Inventor: HE, Ning, 311599 Hangzhou, Zhejiang (CN); JIANG, Haowei, 311599 Hangzhou, Zhejiang (CN); TIAN, Yongqiang, 311599 Hangzhou, Zhejiang (CN); WU, Hengxin, 311599 Hangzhou, Zhejiang (CN)
(74) Representative: Berggren Oy

(57) **Abstract**

This application provides a photovoltaic inverter system, a grid-connected inverter and a relay failure detection method thereof, which controls either the first relay, the second relay or both to close before the grid-connected inverter is connected to the grid, obtains the voltage information of the output end of the inverter circuit and the grid and the sum of the current of each phase branch; determining the fault detection result of the first relay and the second relay according to the voltage information or the sum of the current. It can not only detect whether the relay is faulty in time, but also prevent the situation where the single-phase relay fault cannot be identified, and improve the accuracy of relay failure detection.

## Description

### Technical Field

The present application belongs to the technical field of inverters, and in particular, relates to a photovoltaic inverter system, a grid-connected inverter and a relay failure detection method thereof.

### Background

In the related art, in order to protect the grid-connected inverter and the power grid, a relay is provided between the alternating current (AC) side of the grid-connected inverter and the power grid to control the flow of power from the grid-connected inverter to the power grid. However, the failure of the relay may cause the power to be unable to be normally output from the grid-connected inverter to the power grid, thereby affecting the performance and stability of the grid-connected inverter and the power grid. Therefore, it is very necessary to detect whether the relay in the grid-connected inverter is faulty in time.

In addition, in photovoltaic power generation systems, grid-connected inverters are generally required to convert the direct current (DC) power generated by solar panels into AC power that can be connected to the AC power grid. During the conversion process, the DC power output by the solar panels needs to be input into the grid-connected inverter to invert the DC power into AC power that can be used by the grid. In order to reduce the losses caused by the operation of the grid-connected inverter itself, the grid-connected inverter usually uses a non-isolated inverter. The solar panels will generate leakage current transmitted to the grid through the non-isolated inverter, which will affect the performance of the grid.

### Summary

The embodiments of the present application provide a photovoltaic inverter system, a grid-connected inverter and a relay failure detection method thereof, which can timely detect whether a relay fails before the grid-connected inverter is connected to the grid.

**In** a first aspect, the present application provides a relay failure detection method for a grid-connected inverter, wherein the grid-connected inverter includes an inverter circuit, at least two phase branches and at least two first capacitors, wherein an input end of the inverter circuit is configured to connect to a DC power supply, and an output end of the inverter circuit is connected to the at least two phase branches so as to connect to a power grid; each of the at least two phase branches includes a first relay and a second relay connected in series; each of the at least two first capacitors has a first end connected to the output end of the inverter circuit and to a corresponding one of the at least two phase branches, and a second end that is grounded; wherein the relay failure detection method includes: controlling either the first relay or the second relay, or both, in each of the at least two phase branches to close before the grid-connected inverter is connected to the power grid; obtaining voltage information about the output end of the inverter circuit and about the power grid and a sum of currents of all the at least two phase branches; determining a fault detection result of the first relay and the second relay according to the voltage information or the sum of the currents.

**In** the embodiment of the present application, before the grid-connected inverter is connected to the grid, either the first relay, the second relay, or both are controlled to close, and the voltage information about the output end of the inverter circuit and about the grid and the sum of the current of each phase branch are obtained; the fault detection result of the first relay and the second relay are determined according to the voltage information or the sum of the current. It can not only detect whether the relay is faulty in time, but also prevent the situation where the single-phase relay fault cannot be identified, and improve the accuracy of relay failure detection.

In a possible implementation, controlling either the first relay or the second relay, or both, in each of the at least two phase branches to close includes: controlling one of the first relay and the second relay to open and controlling another one of the first relay and the second relay to close; and wherein determining the fault detection result of the first relay and the second relay according to the voltage information or the sum of the currents includes: determining that the one of the first relay and the second relay to be controlled to open has a sticking fault when the voltage information satisfies a preset voltage condition or the sum of the currents is greater than a preset current threshold; and determining that the one of the first relay and the second relay to be controlled to open does not have a sticking fault when the voltage information does not satisfy the preset voltage condition and the sum of the currents is less than the preset current threshold.

In a possible implementation, controlling either the first relay or the second relay, or both, in each of the at least two phase branches to close includes: controlling the first relay and the second relay to close; and wherein determining the fault detection result of the first relay and the second relay according to the voltage information or the sum of the currents includes: determining that at least one of the first relay and the second relay has an open circuit fault when the voltage information does not satisfy the preset voltage condition and the sum of the currents is greater than a preset current threshold; and determining that neither the first relay nor the second relay has the open circuit fault when the voltage information satisfies the preset voltage condition or the sum of the currents is less than the preset current threshold.

In a possible implementation, the obtaining of the voltage information about the output end of the inverter circuit and the power grid includes:
obtaining a capacitor voltage of each of the first capacitors and a corresponding phase voltage of the power grid;
determining a voltage difference according to the capacitor voltage and the phase voltage, wherein the voltage information comprises the voltage difference value.

In a possible implementation, obtaining the voltage information about the output end of the inverter circuit and about the power grid includes: obtaining an effective value of an output voltage of the output end of the inverter circuit in a preset time period and an effective value of a grid voltage of the power grid in the preset time period; wherein the preset time period includes at least one grid cycle; and determining a voltage difference according to the effective value of the output voltage and the effective value of the grid voltage, wherein the voltage information includes the voltage difference.

In a possible implementation, obtaining the voltage information about the output end of the inverter circuit and about the power grid includes: obtaining an effective value of the capacitor voltage of each of the at least two first capacitors during a preset time period and an effective value of a phase voltage at a connection end of each of the at least two phase branches to the power grid during the preset time period; wherein the preset time period includes at least one power grid cycle; determining a voltage difference according to the effective value of the capacitor voltage and the effective value of the phase voltage, wherein the voltage information includes the voltage difference.

In a possible implementation, the preset voltage condition includes that the voltage difference is less than a preset voltage threshold.

In a possible implementation, obtaining the sum of the currents of all the at least two phase branches includes: obtaining effective values of currents of all of the at least two phase branches in a preset time period, and calculating a sum of the effective values of the currents to obtain the sum of the currents; wherein the preset time period includes at least one power grid cycle.

In a second aspect, the present application provides a grid-connected inverter, including an inverter circuit, a control circuit, at least two phase branches and at least two first capacitors, wherein an input end of the inverter circuit is configured to connect to a DC power supply, and an output end of the inverter circuit is connected to the at least two phase branches so as to connect to a power grid; each of the at least two phase branches includes a first relay and a second relay connected in series; each of the at least two first capacitors has a first end connected to the output end of the inverter circuit and to a corresponding one of the at least two phase branches, and a second end that is grounded; the control circuit is connected to the first relay and the second relay in each of the at least two phase branches; wherein the control circuit is configured for: controlling either the first relay or the second relay, or both, in each of the at least two phase branches to close before the grid-connected inverter is connected to the power grid; obtaining voltage information about the output end of the inverter circuit and about the power grid and a sum of currents of all the at least two phase branches; determining a fault detection result of the first relay and the second relay according to the voltage information or the sum of the currents.

In a possible implementation, each of the at least two phase branches further includes: a first inductor, having a first end connected to the output end of the inverter circuit, and a second end connected to a first end of the first relay in the phase branch, wherein a second end of the first relay is connected to a first end of the second relay in the phase branch: and a second inductor, having a first end connected to the second end of the second relay, and a second end connected to the power grid, wherein the first end of the first capacitor in the phase branch is connected to the second end of the first inductor.

In a possible implementation, the number of the phase branches is three, the number of the first capacitors is three, and the output end of the inverter circuit includes three output terminals; the first ends of the first inductors of the three phase branches are respectively connected to three output terminals of the inverter circuit, and the second ends of the second inductors of the three phase branches are respectively connected to a neutral terminal and two live terminals of the power grid.

In a possible implementation, the grid-connected inverter further includes a DC bus, two bus capacitors and three second capacitors; wherein the input end of the inverter circuit is connected to the DC power supply by the DC bus, and the two bus capacitors are connected in series to the DC bus; each of the three second capacitors has a first end connected to the second end of the first inductor in a corresponding one of the three phase branches, and a second end connected to a connection midpoint of the two bus capacitors.

In a possible implementation, the grid-connected inverter further includes at least two current detection circuits each connected between one of the at least two phase branches and the power grid, wherein at least two current detection circuits are each configured to detect the current of the phase branch.

In a possible implementation, the grid-connected inverter further includes three current detection circuits each connected between one of the three phase branches and the power grid, wherein three current detection circuits are each configured to detect the current of the phase branch.

In a third aspect, the present application provides a photovoltaic inverter system, characterized by comprising:
a photovoltaic module; and
the above grid-connected inverter.

### Brief Description of the Drawings

FIG. 1 is a schematic diagram of the circuit structure of a grid-connected inverter according to an embodiment of the present application.
FIG. 2 is a flow chart of a relay failure detection method according to an embodiment of the present application.
FIG. 3 is a flow chart of a relay failure detection method according to another embodiment of the present application.
FIG. 4 is a flow chart of a relay failure detection method according to another embodiment of the present application.
FIG. 5 is a detailed flow chart of step S120 in FIG. 2 to FIG. 4 according to a specific example of the present application.
FIG. 6 is a schematic diagram of a detailed flow chart of step S120 in FIG. 2 to FIG. 4 according to another specific example of the present application.
FIG. 7 is a schematic diagram showing the structure of a photovoltaic inverter system according to an embodiment of the present application.

### Detailed Description of the Embodiments

It should be noted that the terms "first" and "second" in the specification, claims and drawings of the present application are used to distinguish similar objects, rather than to describe a specific order or sequence. In the specification, claims and drawings of the present application, unless otherwise specified, "/" means or, for example, A/B can mean A or B. For example, A and/or B can mean: A exists alone, A and B exist at the same time, and B exists alone. In addition, the term "a plurality of" in the specification, claims and drawings of the present application refers to two or more than two.

It is understandable that the connection described in the present application refers to direct or indirect connection. For example, A is connected to B or A is electrically connected to B, which may be either A and B are directly connected or A and B are indirectly connected through one or more other electrical components, for example, A and C may be directly connected, and C may be directly connected to B, so that A and B are connected through C.

It should also be noted that the method disclosed in the embodiments of the present application or the method shown in the flowchart includes one or more steps for implementing the method. Without departing from the scope of the claims, the execution order of multiple steps can be interchangeable with each other, and some of the steps can also be deleted.

Some embodiments will be described below in conjunction with the accompanying drawings. In the absence of conflict, the following embodiments and features in the embodiments may be combined with each other.

In a photovoltaic power generation system, a grid-connected inverter is generally required to convert the DC power generated by the solar panels into AC power that can be connected to the AC power grid. During the conversion process, the DC power output by the solar panels needs to be input into the grid-connected inverter to invert the DC power into AC power that can be used by the power grid.

In order to control the power from the grid-connected inverter to the mains grid, a relay is provided between the AC side of the grid-connected inverter and the grid to control the flow of power from the grid-connected inverter to the mains grid. In order to achieve the purpose of safety and redundancy, a double relay is also provided between the inverter and the main grid. However, the failure of the relay may cause the power to be unable to be normally output from the grid-connected inverter to the mains grid, affecting the performance and stability of the grid-connected inverter and the mains grid. Therefore, timely detection of relay failure can ensure the performance and stability of the grid-connected inverter and the mains grid. Relay failure usually includes two situations: relay sticking failure (that is, the relay cannot be disconnected normally) and relay open circuit failure (that is, the relay cannot be normally attracted).

At present, the fault of the relay is generally determined by detecting the output voltage of the grid-connected inverter side and the grid voltage and comparing them. However, before the grid-connected inverter is connected to the grid, the inverter has not started working. If only one phase of the relay connected to the output phase line of the grid-connected inverter has a sticking fault, the grid-connected inverter and the mains grid have no loop at this time, and the voltage on the AC side of the grid-connected inverter will not rise with the grid voltage. It is impossible to determin that the relay has a sticking fault based on the small difference between the voltage on the AC side of the grid-connected inverter and the grid voltage. In other words, it is impossible to detect the situation where the grid-connected inverter has a single-phase relay sticking fault.

In view of this, an embodiment of the present application provides a photovoltaic inverter system, a grid-connected inverter and a relay failure detection method thereof, which determines whether the relay is faulty through the voltage information at the output end of the inverter circuit and the sum of the currents of each phase branch, thereby preventing the situation where a single-phase relay sticking fault cannot be detected.

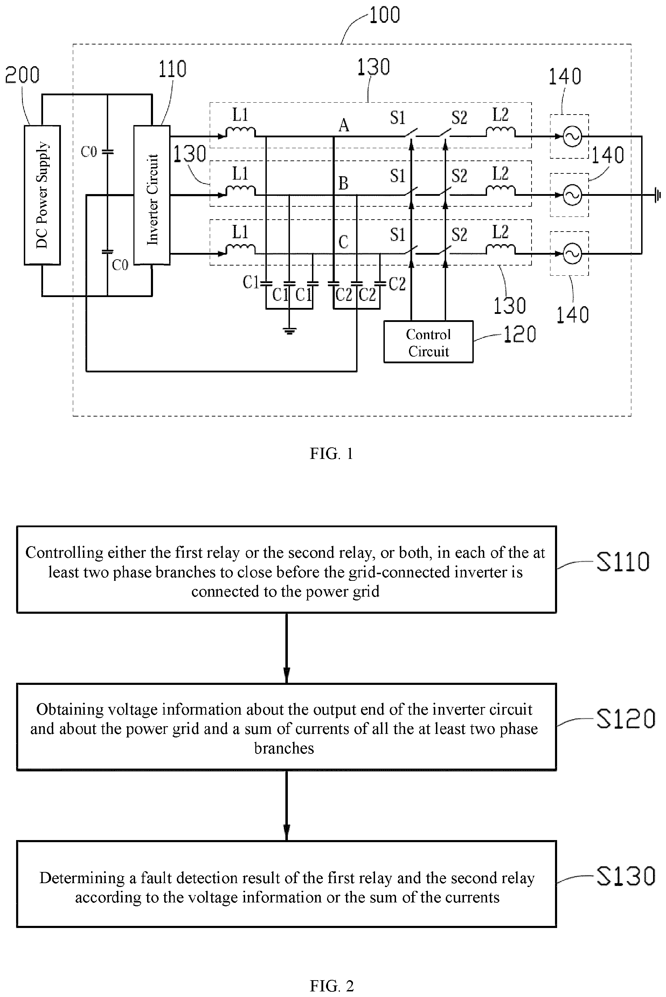

Please refer to Fig. 1, which is a schematic diagram of a circuit structure of a grid-connected inverter 100 according to an embodiment of the present application. The grid-connected inverter 100 includes an inverter circuit 110, a control circuit 120, at least two phase branches 130 and at least two first capacitors C1.

The input end of the inverter circuit 110 is used to connect to the DC power supply 200, and the output end of the inverter circuit 110 is connected to the power grid through the at least two phase branches 130. In the embodiment of the present application, the DC power supply 200 may be a photovoltaic component, an energy storage battery, etc., wherein the photovoltaic component can be a solar cell package, a photovoltaic panel, etc.

Each phase branch 130 includes a first relay S1 and a second relay S2 connected in series. The first end of each first capacitor C1 is connected between the output end of the inverter circuit 110 and the corresponding phase branch 130, and the second end of the first capacitor C1 is grounded. The control circuit 120 is connected to the first relay S1 and the second relay S2.

The control circuit 120 is used to control either the first relay S1 or the second relay S2, or both, to close before the grid-connected inverter 100 is connected to the grid, and obtain the voltage information of the output end of the inverter circuit 110 and the grid and the sum of the current of each phase branch 130. The control circuit 120 determines the fault detection result of the first relay S1 and the second relay S2 according to the obtained voltage information or the sum of the current.

In the embodiment of the present application, the voltage information may include the voltage of the connection end between the phase branches 130 and the output end of the inverter circuit 110, and the grid voltage. A preset voltage condition may be that the voltage difference between the voltage of the connection end between the phase branches 130 and the output end of the inverter circuit 110 and the grid voltage is less than a preset voltage threshold. The control circuit 120 may include a microcontroller unit (MCU), an energy management system (EMS), a central processing unit (CPU), other general-purpose processors, a digital signal processor (DSP), an application-specific integrated circuit (ASIC) or other programmable logic devices, discrete gate or transistor logic devices, discrete hardware components, etc. The general-purpose processor may be a microprocessor or the processor may also be any conventional processor, etc.

Specifically, in order to detect whether the first relay S1 and the second relay S2 have a sticking fault, the control circuit 120 can control one of the first relay S1 and the second relay S2 in each phase branch 130 to be disconnected and the other to be closed, and obtain the voltage information of the output end of the inverter circuit 110 and the power grid at this time and the sum of the currents of each phase branch 130. When the voltage information meets the preset voltage condition or the sum of the currents is greater than a preset current threshold, the control circuit 120 determines that there is a sticking fault in at least one disconnected relay of the phase branch 130 in the grid-connected inverter 100. When the voltage information meets the non-preset voltage condition and the sum of the currents is less than the preset current threshold, the control circuit 120 determines that there is no sticking fault in the disconnected relay of the phase branch 130 in the grid-connected inverter 100.

Specifically, before the grid-connected inverter 100 is connected to the grid, if the first relay S1 and the second relay S2 are both turned on, the grid will charge the corresponding first capacitor C1 through the turned-on first relay S1 and the second relay S2, and then the phase branch 130 will generate leakage current. Therefore, if the sum of the currents of the phase branch 130 obtained by the control circuit 120 is greater than the preset current threshold when one of the first relay S1 and the second relay S2 is controlled to be disconnected and the other is closed, it means that there is at least one phase branch 130 where the first relay S1 and the second relay S2 are both turned on, indicating that the relay to be controlled to be disconnected by the control circuit 120 cannot be disconnected normally, that is, the relay has a sticking fault. When at least one of the first relay S1 and the second relay S2 is to be disconnected, since no path is formed between the inverter circuit 110 and the power grid, the voltage at the output end of the inverter circuit 110 will be different from the power grid voltage. At this time, if the voltage information obtained by the control circuit 120 meets the preset voltage condition, it means that the voltage at the output end of the inverter circuit 110 is the same as or close to the power grid voltage, indicating that the first relay S1 and the second relay S2 of the phase branch 130 are both turned on, indicating that the relay to be controlled to be disconnected by the control circuit 120 cannot be disconnected normally, that is, the relay has a sticking fault. Therefore, it can be determined whether the relay is to be disconnected at this moment has a sticking fault based on the voltage information or the sum of the currents of the phase branches 130. When a relay to be disconnected from a single phase branch 130 has a sticking fault, the voltage information alone cannot determine whether the relay has a sticking fault, but it can be determined whether the relay has a sticking fault based on whether the sum of the currents of the acquired phase branches 130 is greater than the preset current threshold. Therefore, the embodiments of the present application can determine whether the relay to be disconnected at this moment has a sticking fault by obtaining the sum of the voltage information of the output end of the inverter circuit 110 and the power grid and the sum of the currents of the phase branches 130, and can also detect and identify when a sticking fault exists in the relay of a single phase branch 130. This can not only detect whether the relay has a fault in a timely manner, but also prevent the situation where a single-phase relay fault cannot be identified, thereby improving the accuracy of relay failure detection.

It can be understood that, in embodiments of the present application, the sum of the currents of the multiple phase branches 130 is obtained by adding the current vectors of the multiple phase branches 130, that is, the current of the acquired phase branch 130 is determined to be positive or negative according to its current flow direction. For example, the current flowing towards the power grid is a positive current, and the current flowing towards the inverter circuit 110 is a negative current, and vice versa.

If the grid-connected inverter 100 includes three phase branches 130, when the first relay S1 and the second relay S2 in the three phase branches 130 are all closed, according to the three-phase current balance principle, the sum of the currents is zero. Therefore, when performing relay failure detection, if the relays in the three phase branches 130 of the grid-connected inverter 100 that are controlled to be disconnected by the control circuit 120 all have a sticking fault, it cannot be determined that the relay has a sticking fault based on the sum of the currents, then it can be determined whether the sticking fault exists based on whether the acquired voltage information meets the preset voltage condition.

In addition, in the grid-connected inverter 100 of the present application, by providing a grounded first capacitor C1 between the output end of the inverter circuit 110 and the phase branch 130, the electromagnetic interference (EMI) of the grid-connected inverter 100 can be improved. In some embodiments, the first capacitor C1 may be configured as a Y capacitor (Safety Fixed capacitor).

It can be understood that in the embodiment of the present application, after the grid-connected inverter 100 receives the power-on command to start, the fault detection on the first relay S1 and the second relay S2 can be automatically started to perform. If it is determined that the relay has a sticking fault, the control circuit 120 can send an indication signal, which may be sent to a display of an electronic device provided with the grid-connected inverter 100 to indicate that the relay has a sticking fault, or may be sent to a user end through a communication device to prompt the user that the grid-connected inverter 100 has a sticking fault.

In an embodiment of the present application, after the control circuit 120 determines that the currently disconnected relay does not have a sticking fault, it can control the relay to close and the other relay to disconnect, and obtain the voltage information of the output end of the inverter circuit 110 and the power grid and the sum of the currents of each phase branch 130 again, and determine whether the relay to be disconnected has a sticking fault based on the voltage information and the sum of the current.

Specifically, before the grid-connected inverter 100 is connected to the grid, the control circuit 120 first controls the first relay S1 to be disconnected and the second relay S2 to be closed, and obtains the voltage information of the output end of the inverter circuit 110 and the grid and the sum of the currents of each phase branch 130. When the voltage information meets the preset voltage condition or the sum of the currents is greater than the preset current threshold, it is determined that there is a sticking fault in the first relay S1 of at least one phase branch 130. When the voltage information does not meet the preset voltage condition and the sum of the currents is less than the preset current threshold, it is determined that there is no sticking fault in the first relay S1 of each phase branch 130. In this way, the detection of whether the first relay S1 has a sticking fault is achieved.

Then, the control circuit 120 controls the first relay S1 to close and the second relay S2 to open, and reacquires the voltage information of the output end of the inverter circuit 110 and the power grid and the sum of the currents of each phase branch 130. When the voltage information meets the preset voltage condition or the sum of the currents is greater than the preset current threshold, it is determined that the second relay S2 of at least one phase branch 130 has a sticking fault. When the voltage information does not meet the preset voltage condition and the sum of the currents is less than the preset current threshold, it is determined that the second relay S2 of each phase branch 130 does not have a sticking fault. In this way, the detection of whether the second relay S2 has a sticking fault is achieved.

In some embodiments, after the control circuit 120 determines that the first relay S1 has a sticking fault, it may stop detecting whether the second relay S2 has a sticking fault, and the grid-connected inverter 100 stops the grid-connected operation.

It is understandable that in order to obtain the sum of the currents of the phase branches 130, a current detection circuit 140 can be connected between each phase branch 130 and the power grid to detects the current of each phase branch 130, and provides the detected current to the control circuit 120, so that the control circuit 120 obtains the sum of the currents of the phase branches 130 by adding the obtained currents. It is understandable that in the embodiment of the present application, the current detection circuit 140 can detect the current of the phase branch 130 within a preset time length , obtain the current effective value of the phase branch 130 according to the current detected within the preset time length, and then add the current effective value of each phase branch 130 to obtain the sum of currents. The positive and negative of the current effective value can be determined according to the current flow direction of the phase branch 130.

Specifically, the current detection circuit 140 may include a current detection meter, which is connected in series between the phase branch 130 and the power grid to detect the current of the phase branch 130. The control circuit 120 obtains the current of each phase branch 130 through the current detection meter, and then obtains the sum of the currents of the phase branches 130.

The control circuit 120 can obtain voltage information of the output end of the inverter circuit 110 and the power grid through the voltage detection circuits.

In addition to the sticking fault, the relay may also have an open circuit fault. Therefore, in some embodiments, the control circuit 120 can also be used to control the first relay S1 and the second relay S2 to close, and obtain the voltage information of the output end of the inverter circuit 110 and the power grid and the sum of the currents of each phase branch 130. When the voltage information does not meet the preset voltage condition and the sum of the currents is greater than the preset current threshold, the control circuit 120 determines that at least one of the first relay S1 and the second relay S2 has an open circuit fault.

Further, when the voltage information satisfies a preset voltage condition or the sum of the currents is less than a preset current threshold, the control circuit 120 determines that neither the first relay S1 nor the second relay S2 has the open circuit fault.

Before the grid-connected inverter 100 is connected to the grid, if the first relay S1 and the second relay S2 of each phase branch 130 of the grid -connected inverter 100 are closed, a path is formed between the inverter circuit 110 and the grid, so that the grid charges the grounded first capacitor C1 and generates leakage current, but the current flow direction of each phase branch 130 is different. According to the current balance principle, the sum of the currents obtained by adding the current vectors of multiple phase branches 130 is zero. Moreover, since the grid charges the first capacitor C1, the voltage at the output end of the inverter circuit 110 and the grid voltage will be the same or similar. When detecting the open circuit fault of the relay, if the voltage information meets the preset voltage condition or the sum of the current is less than the preset current threshold, it means that a path can be formed between the inverter circuit 110 and the grid, and the first relay S1 and the second relay S2 of each phase branch 130 do not have an open circuit fault.

If the voltage information does not meet the preset voltage condition and the sum of the currents is greater than the preset current threshold, it means that no path is formed between at least one phase branch 130 of the grid-connected inverter 100 and the grid, that is, at least one of the first relay S1 and the second relay S2 of the at least one phase branch 130 has an open circuit fault.

In some embodiments, the inverter circuit 110 may include at least two output terminals, and the power grid includes at least two connection terminals, and each output terminal is respectively connected to a connection terminal of the power grid through a phase branch 130. Correspondingly, the voltage information of the output end of the inverter circuit 110 and the power grid may be: the effective value of the voltage between every two output terminals of the inverter circuit 110 and the effective value of the voltage between every two connection terminals of the power grid.

In some other embodiments, the voltage information of the output end of the inverter circuit 110 and the power grid may also be: the capacitance voltage of each first capacitor C1, and the phase voltage of each connection terminal of the power grid. Furthermore, the voltage information of the output end of the inverter circuit 110 and the power grid may also be: the effective value of the capacitor voltage of each first capacitor C1, and the effective value of the phase voltage of each connection terminal of the power grid.

Please refer to FIG. 1 again. In some embodiments, each phase branch 130 further includes a first inductor L1 and a second inductor L2. The first end of the first inductor L1 is connected to the output end of the inverter circuit 110. The second end of the first inductor L1 is correspondingly connected to the first end of the first relay S1. The second end of the first relay S1 is connected to the first end of the second relay S2. The first end of the second inductor L2 is correspondingly connected to the second end of the second relay S2. The second end of the second inductor L2 is connected to the power grid. The first end of the first capacitor C1 is connected to the second end of the first inductor.

Further, the phase branches 130 may include three phase branches A, B, and C, respectively, and the first capacitors C1 may include three first capacitors C1. The first ends of the first inductors L1 of the three phase branches 130 are respectively connected to the three output terminals of the inverter circuit 110, and the second ends of the second inductors L2 of the three phase branches 130 are respectively connected to the neutral terminal and two live terminals of the power grid.

In this example, the grid-connected inverter 100 is a three-phase grid-connected inverter.

It is understandable that the grid-connected inverter 100 may also include a DC bus (not marked in the figures), two bus capacitors C0 and three second capacitors C2. The input end of the inverter circuit 110 is connected to the DC power supply 200 through the DC bus, and the two bus capacitors C0 are connected in series to the DC bus; the first end of each second capacitor C2 is correspondingly connected to the second end of the first inductor L1, and the second end of each second capacitor C2 is connected to the connection midpoint of the two bus capacitors C0.

The DC power supply 200 charges two bus capacitors Co through the DC bus, and then the power of the DC power supply 200 is provided to the inverter circuit 110 to convert it into AC power. The second capacitor C2 can stabilize and filter the voltage at the output end of the inverter circuit 110.

Specifically, the three second capacitors C2 are respectively connected to the second end of the first inductor L1 of a corresponding phase branch 130. The first inductor L1, the second inductor L2 and the second capacitor C2 form an LCL filter circuit to filter out noise of each phase branch 130.

Please refer to FIG. 2, which shows a schematic flow chart of a relay failure detection method for a grid-connected inverter 100 according to an embodiment of the present application. In at least one embodiment, the relay failure detection method is applied to the grid-connected inverter 100 as described above, and the relay failure detection method can be executed by the above-mentioned control circuit 120. For the convenience of description, the following description is made by taking the application of the relay failure detection method to the grid-connected inverter 100 shown in FIG. 1 as an example.

As shown in FIG. 2, the relay failure detection method specifically includes the following steps S110-S130.

S110, controlling either the first relay or the second relay, or both, in each of the at least two phase branches to close before the grid-connected inverter is connected to the power grid.

For example, the control circuit 120 can control one of the first relay S1 and the second relay S2 to be opened and the other to be closed before the grid-connected inverter 100 is connected to the grid. The control circuit 120 can also control both the first relay S1 and the second relay S2 to be closed before the grid-connected inverter 100 is connected to the grid.

S120, obtaining voltage information about the output end of the inverter circuit and about the power grid and a sum of currents of all the at least two phase branches.

The control circuit 120 can obtain voltage information of the output end of the inverter circuit 110 and the power grid through the voltage detection circuit, obtain the current of the phase branches 130 through the current detection circuits 140, and then obtain the sum of the currents.

The inverter circuit 110 may include at least two output terminals, and the power grid may include at least two connection terminals, each of which is connected to a connection terminal of the power grid through a phase branch 130. Correspondingly, the voltage information of the output end of the inverter circuit 110 and the power grid may be: the effective value of the voltage between every two output terminals of the inverter circuit 110 and the effective value of the voltage between every two connection terminals of the power grid. The current detection circuit 140 obtains the current of the phase branch 130 as a vector value, and the obtained current may be the effective value of the current.

In some other embodiments, the voltage information of the output end of the inverter circuit 110 and the power grid may be: the effective value of the capacitor voltage of each first capacitor C1, and the effective value of the phase voltage of each connection terminal of the power grid.

In the embodiment of the present application, the preset current threshold value may be set according to the leakage current that the grid-connected inverter 100 can generate, for example, it may be set to 10 mA, 20 mA, etc. It can be understood that the preset current threshold value can be obtained according to experiments, for example, the first relay S1 and the second relay S2 of one of the phase branches 130 are controlled to be closed, and either the first relay S1, the second relay S2, or both in any other phase branch 130 are controlled to be disconnected, and the current value on each phase branch 130 is detected (in this case, the power grid charges the first capacitor C1 connected to the phase branch 130 where the first relay S1 and the second relay S2 are controlled to be closed to generate leakage current), and the detected current values are added as the preset current threshold value. Alternatively, the first relay S1 and the second relay S2 of each phase branch 130 can be controlled to be closed in sequence, and the current value on each phase branch 130 is detected each time, and the detected current values are added to obtain the sum of currents, and the average value of the multiple sums of currents is calculated, and the average value is used as the preset current threshold value. It can be understood that when the preset current threshold is obtained through experiments, each of the first relay S1 and the second relay S2 in the grid-connected inverter 100 used does not have a sticking fault and an open circuit fault.

S130, determining a fault detection result of the first relay and the second relay according to the voltage information or the sum of the currents.

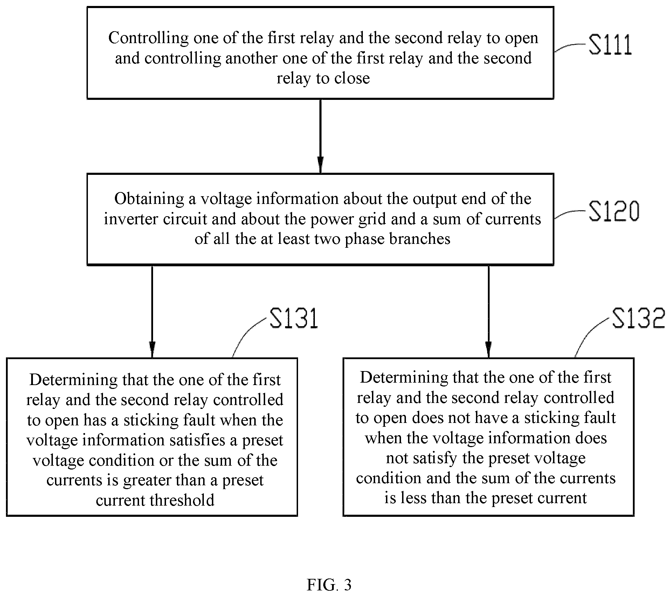

Referring to FIG. 3, in some embodiments, step S110 includes:
S111, controlling one of the first relay and the second relay to open and controlling another one of the first relay and the second relay to close.

Correspondingly, step S130 includes:
S131, determining that the one of the first relay and the second relay controlled to open has a sticking fault when the voltage information satisfies a preset voltage condition or the sum of the currents is greater than a preset current threshold;
S132, determining that the one of the first relay and the second relay controlled to open does not have a sticking fault when the voltage information does not satisfy the preset voltage condition and the sum of the currents is less than the preset current threshold.

It can be understood that the grid-connected inverter 100 can repeat steps S111 to S131/S132 twice. When the steps S111 to S131/S132 are performed for the first time, the first relay S1 may be controlled to be disconnected and the second relay S2 may be controlled to be closed, so as to determine whether the first relay S1 has a sticking fault according to the obtained voltage information and the sum of the current. When the steps S111 to S131/S132 are performed for the second time, the first relay S1 may be controlled to be closed and the second relay S2 may be controlled to be disconnected, so as to determine whether the second relay S2 has a sticking fault according to the obtained voltage information and the sum of the currents.

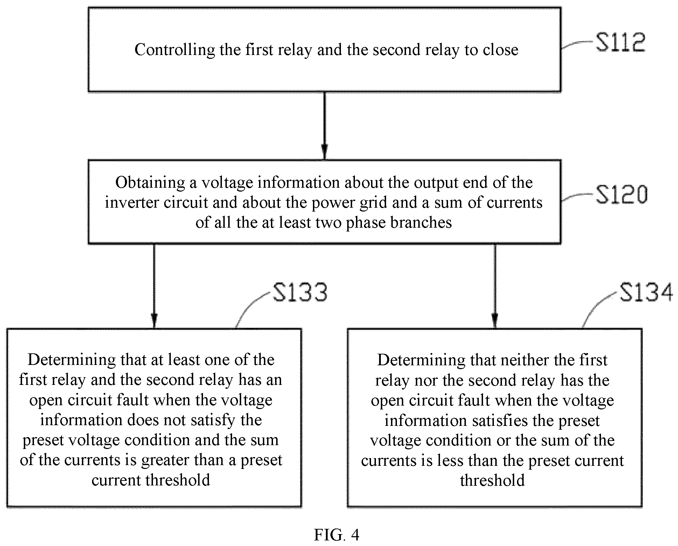

It is understandable that the first relay S1 and the second relay S2 may also have an open circuit fault. Referring to FIG. 4, in order to detect the open circuit fault, step S110 may also include:
S112, controlling the first relay and the second relay to close.

Correspondingly, step S130 may include:
S133, determining that at least one of the first relay and the second relay has an open circuit fault when the voltage information does not satisfy the preset voltage condition and the sum of the currents is greater than a preset current threshold.
S134, determining that neither the first relay nor the second relay has the open circuit fault when the voltage information satisfies the preset voltage condition or the sum of the currents is less than the preset current threshold.

It can be understood that in some embodiments, steps S112 to S133/S134 can be performed after the grid-connected inverter 100 executes steps S111 to S131/S132, or before the grid-connected inverter 100 executes steps S111 to S131/S132. Alternatively, steps S112 to S133/S134 can be performed after the grid-connected inverter 100 executes step S132, that is, after the grid-connected inverter 100 determines that its relays do not have a sticking fault, it executes steps S112 to S133/S134 to determine whether its relays have an open circuit fault. After the grid-connected inverter 100 executes step S131 to determine that its relays have a sticking fault, it may no longer continue to execute steps S112 to S133/S134.

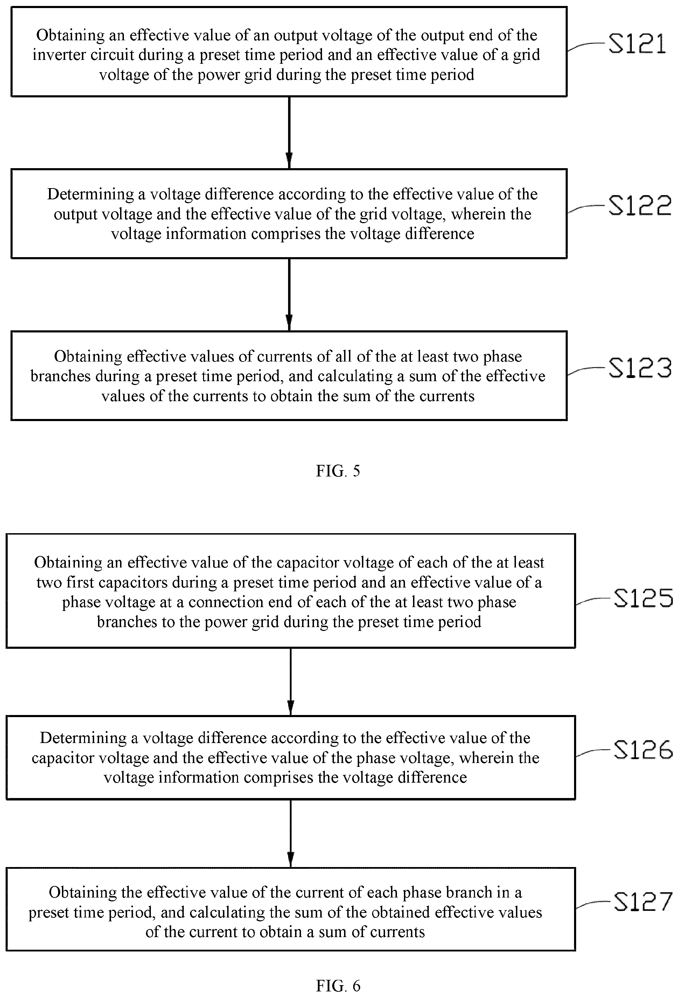

Please refer to FIG. 5. In some embodiments, step S120 may specifically include steps S121 to S123.

S121, obtaining an effective value of an output voltage of the output end of the inverter circuit during a preset time period and an effective value of a grid voltage of the power grid during the preset time period.

The preset time period includes at least one grid cycle, that is, the preset time period is set according to the cycle of the grid. The effective value of the output voltage of the output end of the inverter circuit 110 in the preset time period refers to the effective value of the voltage between every two output terminals of the inverter circuit 110. The effective value of the grid voltage refers to the effective value of the voltage between every two phase line terminals of the grid. Specifically, as shown in FIG. 1, when the grid-connected inverter 100 is a three-phase grid-connected inverter 100, the inverter circuit 110 includes three output terminals, and the grid includes two live terminals and one neutral terminal. Correspondingly, the effective value of the output voltage of the output end of the inverter circuit 110 in the preset time period refers to the effective value UAB_AVE of the voltage between the output terminal of the inverter circuit 110 connected to the phase branch A and the output terminal of the inverter circuit 110 connected to the phase branch B, the effective value UBC_AVE of the voltage between the output terminal of the inverter circuit 110 connected to the phase branch B and the output terminal of the inverter circuit 110 connected to the phase branch C, and the effective value UCA_AVE of the voltage between the output terminal of the inverter circuit 110 connected to the phase branch C and the output terminal of the inverter circuit 110 connected to the phase branch A. The effective value of the grid voltage refers to the effective value EAB_AVE of the voltage between the live terminal of the grid connected to the phase branch A and the neutral terminal of the grid connected to the phase branch B, the effective value EBC_AVE of the voltage between the neutral terminal of the grid connected to the phase branch B and the live terminal of the grid connected to the phase branch C, and the effective value ECA_AVE of the voltage between the live terminal of the grid connected to the phase branch C and the live terminal of the grid connected to the phase branch A.

S122, determining a voltage difference according to the effective value of the output voltage and the effective value of the grid voltage, wherein the voltage information comprises the voltage difference.

It can be understood that the voltage information includes a voltage difference. The voltage difference refers to the difference between the effective value of the output voltage and the corresponding effective value of the grid voltage. For example, it refers to the difference |UAB_AVE-EAB_AVE| between the effective value UAB_AVE and the effective value EAB_AVE, the difference |UBC_AVE-EBC_AVE| between the effective value UBC_AVE and the effective value EBC_AVE, and the difference |UCA_AVE-ECA_AVE| between the effective value UCA_AVE and the effective value ECA_AVE.

Based on this, the preset voltage condition may include that the voltage difference is less than the preset voltage threshold, that is, each voltage difference is less than the preset voltage threshold. The "voltage information satisfies the preset voltage condition" in step S131 and step S134 includes: |UAB_AVE-EAB_AVE|, |UBC_AVE-EBC_AVE|, |UCA_AVE-ECA_AVE| are all less than the preset voltage threshold. The preset voltage threshold may be set to 10V, 20V, etc.

The "voltage information does not satisfy the preset voltage condition" in step S132 and step S133 includes: |UAB_AVE-EAB_AVE|, |UBC_AVE-EBC_AVE|, |UCA_AVE-ECA_AVE| are all greater than the preset voltage threshold.

S123, obtaining effective values of currents of all of the at least two phase branches during a preset time period, and calculating a sum of the effective values of the currents to obtain the sum of the currents; wherein the preset time period comprises at least one power grid cycle.

For example, when the grid-connected inverter 100 includes three phase branches 130, the effective value of the current of each phase branch 130 is IA_AVE, IB_AVE and IC_AVE respectively, and the sum of the currents is IA_AVE + IB_AVE + IC_AVE. It can be understood that the grid-connected inverter 100 can detect the effective value of the current of each phase branch 130 by providing a current detection circuit 140 between each phase branch 130 and the power grid.

Please refer to FIG. 6, in some other embodiments, step S120 may specifically include steps S125-S127.

S125, obtaining an effective value of the capacitor voltage of each of the at least two first capacitors during a preset time period and an effective value of a phase voltage at a connection end of each of the at least two phase branches to the power grid during the preset time period; wherein the preset time period comprises at least one power grid cycle.

The preset time period includes at least one power grid cycle. For example, when the grid-connected inverter 100 is a three-phase grid-connected inverter 100, it includes three first capacitors C1 respectively connected to three phase branches 130. Correspondingly, the effective values of the capacitor voltages of the three first capacitors C1 in the preset time period and the effective values of the phase voltages of the neutral terminal and two live terminals of the power grid in the preset duration are obtained. Specifically, the obtained effective values of the capacitor voltages include: the effective value of the capacitor voltage UA_AVE of the first capacitor C1 connected to the phase branch A, the effective value of the capacitor voltage UB_AVE of the first capacitor C1 connected to the phase branch B, and the effective value of the capacitor voltage UC_AVE of the first capacitor C1 connected to the phase branch C. The obtained effective values of the phase voltages include: the effective value of the phase voltage EA_AVE of the live terminal of the power grid connected to the phase branch A, the effective value of the phase voltage EB_AVE of the neutral terminal connected to the phase branch B, and the effective value of the phase voltage EC_AVE of the live terminal connected to the phase branch C. Since the first capacitors C1 are grounded, when the relays of a single phase branch 130 of the grid-connected inverter 100 have a sticking fault, the control circuit 120 controls one of the first relay S1 and the second relay S2 to be disconnected and the other to be closed when performing sticking fault detection. The phase branch 130 with the sticking fault is conducting, and the power grid charges the corresponding first capacitor C1 through the phase branch 130, so that the voltage of the first capacitor C1 is raised, and then according to the effective value of the capacitor voltage of the first capacitor C1, it can be determined whether the relays in the phase branch 130 have a sticking fault.

When an open-circuit fault occurs in the relays of a single phase branch 130 of the grid-connected inverter 100, if the control circuit 120 performs open-circuit fault detection and controls the first relay S1 and the second relay S2 to be closed, the phase branch 130 with the open-circuit fault is actually disconnected, and the power grid cannot charge the corresponding first capacitor C1 through the phase branch 130, so that the voltage of the first capacitor C1 is not raised, and then, based on whether the voltage difference between the effective value of the capacitor voltage of the first capacitor C1 and the effective value of the corresponding phase voltage is less than the preset voltage threshold, it can be determined whether the relays in the phase branch 130 have an open-circuit fault.

S126, determining a voltage difference according to the effective value of the capacitor voltage and the effective value of the phase voltage, wherein the voltage information comprises the voltage difference.

It can be understood that the voltage information includes the voltage difference. The voltage difference refers to the difference between the effective value of the capacitor voltage and the effective value of the corresponding phase voltage. For example, the difference |UA_AVE-EA_AVE| between the effective value of the capacitor voltage UA_AVE and the effective value of the phase voltage EA_AVE, the difference |UB_AVE-EB_AVE| between the effective value of the capacitor voltage UB_AVE and the effective value of the phase voltage EB_AVE, and the difference |UC_AVE-EC_AVE| between the effective value of the capacitor voltage UC_AVE and the effective value of the phase voltage EC_AVE.

Based on this, the preset voltage condition may include that the voltage difference is less than the preset voltage threshold, that is, each voltage difference is less than the preset voltage threshold. The "voltage information satisfies the preset voltage condition" in step S131 and step S134 includes: |UA_AVE-EA_AVE|, |UB_AVE-EB_AVE|, |UC_AVE-EC_AVE| are each less than the preset voltage threshold.

The "voltage information does not satisfy the preset voltage condition" in step S132 and step S133 includes: |UA_AVE-EA_AVE|, |UB_AVE-EB_AVE|, |UC_AVE-EC_AVE| are each greater than the preset voltage threshold.

S127, obtaining the effective value of the current of each phase branch in a preset time period, and calculating the sum of the obtained effective values of the current to obtain a sum of currents.

It can be understood that the beneficial effects that can be achieved by the relay failure method according to the embodiment of the present application may refer to the beneficial effects of the corresponding grid-connected inverter 100 provided above, and will not be repeated here.

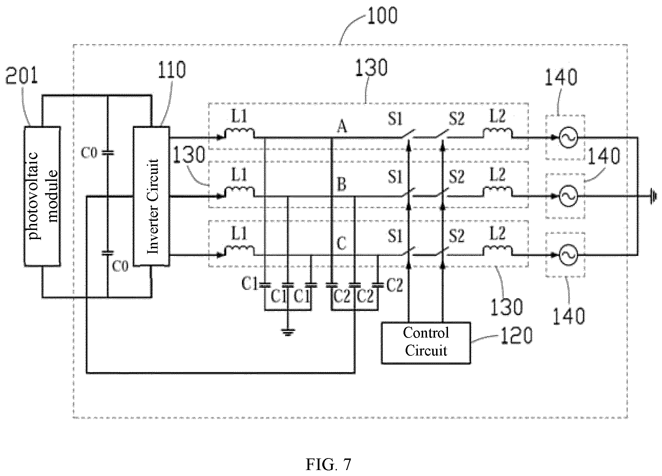

Please refer to FIG. 7. the present application also provides a photovoltaic inverter system 10, including a photovoltaic module 201 and a grid-connected inverter 100 as described above. The photovoltaic module 201 is connected to the input end of the inverter circuit 110.

The photovoltaic module 201 is configured to convert solar energy into electrical energy, and then provide the electrical energy to the inverter circuit 110 to convert it into alternating current, and then provide it to the power grid.

In some embodiments, the photovoltaic inverter system 10 may also include a maximum power point tracking (MPPT) circuit (not shown). The input end of the MPPT circuit is connected to the output end of the photovoltaic module 201, and the output end of the MPPT circuit is connected to the DC input end of the inverter circuit 110. The MPPT circuit can be used to perform maximum power tracking on the photovoltaic module 201, so that the photovoltaic module 201 operates at the maximum power point, and the inverter circuit 110 is connected to the maximum power PMAX of the photovoltaic module 201, and then the connected power is inverted.

The MPPT circuit may be, for example, a boost circuit, and the present application does not limit the specific topology of the MPPT circuit.

Finally, it should be noted that the above embodiments are only used to illustrate the technical solutions of the present application and are not intended to limit them. In the actual application process, the entire content of the technical solutions described in any embodiment of the present application can be implemented, or some content can be added, or some content can be deleted, or some content can be changed/replaced. Although the present application is described in detail with reference to the preferred embodiments, it should be understood by those of ordinary skill in the art that the technical solutions of the present application can be modified or replaced by equivalents without departing from the spirit and scope of the technical solutions of the present application.

## Claims

1. A relay failure detection method for a grid-connected inverter (100), **characterized in that** the grid-connected inverter (100) comprises an inverter circuit (110), at least two phase branches (130) and at least two first capacitors (C1), wherein an input end of the inverter circuit (110) is configured to connect to a direct current (DC) power supply (200), and an output end of the inverter circuit (110) is connected to the at least two phase branches (130) so as to connect to a power grid; each of the at least two phase branches (130) comprises a first relay (S1) and a second relay (S2) connected in series; each of the at least two first capacitors (C1) has a first end connected to the output end of the inverter circuit (110) and to a corresponding one of the at least two phase branches (130), and a second end that is grounded;
wherein the relay failure detection method comprises:
controlling (S110) either the first relay (S1) or the second relay (S2), or both, in each of the at least two phase branches (130) to close before the grid-connected inverter (100) is connected to the power grid;
obtaining (S120) voltage information about the output end of the inverter circuit (110) and about the power grid and a sum of currents of all the at least two phase branches (130); and
determining (S130) a fault detection result of the first relay (S1) and the second relay (S2) according to the voltage information or the sum of the currents.

2. The relay failure detection method according to claim 1, **characterized in that** the controlling (S110) of either the first relay (S1) or the second relay (S2), or both, in each of the at least two phase branches (130) to close comprises: controlling (S111) one of the first relay (S1) and the second relay (S2) to open and controlling another one of the first relay (S1) and the second relay (S2) to close; and
wherein determining (S130) the fault detection result of the first relay (S1) and the second relay (S2) according to the voltage information or the sum of the currents comprises:
determining (S131) that the one of the first relay (S1) and the second relay (S2) controlled to open has a sticking fault when the voltage information satisfies a preset voltage condition or the sum of the currents is greater than a preset current threshold; and
determining (S132) that the one of the first relay (S1) and the second relay (S2) controlled to open does not have a sticking fault when the voltage information does not satisfy the preset voltage condition and the sum of the currents is less than the preset current threshold.

3. The relay failure detection method according to claim 1, **characterized in that** the controlling (S110) of either the first relay (S1) or the second relay (S2), or both, in each of the at least two phase branches (130) to close comprises: controlling (S112) the first relay (S1) and the second relay (S2) to close; and
wherein determining the fault detection result of the first relay (S1) and the second relay (S2) according to the voltage information or the sum of the currents comprises:
determining (S133) that at least one of the first relay (S1) and the second relay (S2) has an open circuit fault when the voltage information does not satisfy the preset voltage condition and the sum of the currents is greater than a preset current threshold; and
determining (S134) that neither the first relay (S1) nor the second relay (S2) has the open circuit fault when the voltage information satisfies the preset voltage condition or the sum of the currents is less than the preset current threshold.

4. The relay failure detection method according to claim 2 or 3, **characterized in that** the obtaining of the voltage information about the output end of the inverter circuit (110) and about the power grid comprises:
obtaining (S121) an effective value of an output voltage of the output end of the inverter circuit (110) during a preset time period and an effective value of a grid voltage of the power grid during the preset time period; wherein the preset time period comprises at least one grid cycle; and
determining (S122) a voltage difference according to the effective value of the output voltage and the effective value of the grid voltage, wherein the voltage information comprises the voltage difference.

5. The relay failure detection method according to claim 2 or 3, **characterized in that** the obtaining of the voltage information about the output end of the inverter circuit (110) and about the power grid comprises:
obtaining a capacitor voltage of each of the first capacitors and a corresponding phase voltage of the power grid;
determining a voltage difference according to the capacitor voltage and the phase voltage, wherein the voltage information comprises the voltage difference value.

6. The relay failure detection method according to claim 4 or 5, **characterized in that** the obtaining of the voltage information about the output end of the inverter circuit (110) and about the power grid comprises:
obtaining (S125) an effective value of the capacitor voltage of each of the first capacitors (C1) during a preset time period and an effective value of a phase voltage at a connection end of each of the at least two phase branches (130) to the power grid during the preset time period; wherein the preset time period comprises at least one power grid cycle;
determining (S126) a voltage difference according to the effective value of the capacitor voltage and the effective value of the phase voltage, wherein the voltage information comprises the voltage difference.

7. The relay failure detection method according to any one of claims 4 to 6, **characterized in that** the preset voltage condition comprises that the voltage difference is less than a preset voltage threshold.

8. The relay failure detection method according to any one of claims 1 to 3, **characterized in that** the obtaining of the sum of the currents of all the at least two phase branches (130) comprises:
obtaining (S123, S127) effective values of currents of all of the at least two phase branches (130) during a preset time period, and calculating a sum of the effective values of the currents to obtain the sum of the currents; wherein the preset time period comprises at least one power grid cycle.

9. A grid-connected inverter (100), **characterized by** comprising an inverter circuit (110), a control circuit (120), at least two phase branches (130) and at least two first capacitors (C1), wherein an input end of the inverter circuit (110) is connected to a direct current (DC) power supply (200), and an output end of the inverter circuit (110) is connected to the at least two phase branches (130) so as to connect to a power grid; each of the at least two phase branches (130) comprises a first relay (S1) and a second relay (S2) connected in series; each of the at least two first capacitors (C1) has a first end connected to the output end of the inverter circuit (110) and to a corresponding one of the at least two phase branches (130), and a second end that is grounded; the control circuit (120) is connected to the first relay (S1) and the second relay (S2) in each of the at least two phase branches (130);
wherein the control circuit (120) is configured to perform the relay failure detection method according to any one of claims 1 to 8.

10. The grid-connected inverter (100) according to claim 9, **characterized in that** each of the at least two phase branches (130) further comprises:
a first inductor (L1), having a first end connected to the output end of the inverter circuit (110), and a second end connected to a first end of the first relay (S1), wherein a second end of the first relay (S1) is connected to a first end of the second relay (S2); and
a second inductor (L2), having a first end connected to the second end of the second relay (S2), and a second end connected to the power grid, wherein the first end of the first capacitor (C1) is connected to the second end of the first inductor (L1).

11. The grid-connected inverter (100) according to claim 10, **characterized in that** the number of the phase branches (130) is three, the number of the first capacitors (C1) is three, and the output end of the inverter circuit (110) comprises three output terminals; the first ends of the first inductors (L1) of the three phase branches (130) are respectively connected to three output terminals of the inverter circuit (110), and the second ends of the second inductors (L2) of the three phase branches (130) are respectively connected to a neutral terminal and two live terminals of the power grid.

12. The grid-connected inverter (100) according to claim 11, **characterized by** further comprising a DC bus, two bus capacitors (C0) and three second capacitors (C2); wherein the input end of the inverter circuit (110) is connected to the DC power supply by the DC bus, and the two bus capacitors (C0) are connected in series to the DC bus; each of the second capacitors (C2) has a first end connected to the second end of the first inductor (L1), and a second end connected to a connection midpoint of the two bus capacitors (C0).

13. The grid-connected inverter (100) according to claim 9 or 10, **characterized by** further comprising at least two current detection circuits (140) each connected between a respective one of the at least two phase branches (130) and the power grid, wherein the at least two current detection circuits (140) are each configured to detect the current of the phase branch (130).

14. The grid-connected inverter (100) according to claim 11 or 12, **characterized by** further comprising three current detection circuits (140) each connected between a respective one of the three phase branches (130) and the power grid, wherein the three current detection circuits (140) are each configured to detect the current of the phase branch (130).

15. A photovoltaic inverter system, **characterized by** comprising:
a photovoltaic module; and
the grid-connected inverter according to any one of claims 9 to 14.
